# EUROPÄISCHE PATENTANMELDUNG

(11) **EP 3 461 697 A1**
(43) Veröffentlichungstag der Anmeldung: **03.04.2019**
(21) Anmeldenummer: 18194987.6
(22) Anmeldetag: 18.09.2018
(51) Int. Cl.: B60R 25/20, E05B 81/76, G07C 9/00, H03K 17/95

(54) **SYSTEM UND VERFAHREN ZUR DETEKTION EINER AKTIVIERUNGSHANDLUNG**

(30) Priorität: 20.09.2017 DE 102017121795
(71) Anmelder: HUF Hülsbeck & Fürst GmbH & Co. KG, 42551 Velbert (DE)
(72) Erfinder: GORENZWEIG, Igor Alexander, 42109 Wuppertal (DE)
(74) Vertreter: Bals, Rüdiger

(57) **Zusammenfassung**

Die Erfindung betrifft ein System (100) zur Detektion einer Aktivierungshandlung (A) bei einem Fahrzeug (1), vorzugsweise eines Wischbewegungsverlaufs (A) bei einem Türgriff (50) und/oder einer Tür des Fahrzeuges (1), mit einem Sensor (10) zur Erfassung einer Induktivitätsveränderung in einem Erfassungsbereich (15), wobei der Sensor (10) wenigstens ein Detektionsmittel (10.1) zur Bereitstellung des Erfassungsbereichs (15) aufweist.

## Beschreibung

Die vorliegende Erfindung betrifft ein System gemäß der im Oberbegriff des Anspruchs 1 näher definierten Art. Ferner bezieht sich die Erfindung auch auf ein Verfahren zur Detektion einer Aktivierungshandlung bei einem Fahrzeug.

Es ist aus dem Stand der Technik bekannt, Sensoren bei einem Fahrzeug zu verwenden, durch welche sich eine Aktivierungshandlung am Fahrzeug detektieren lässt. Bspw. kommen hierzu Näherungssensoren zum Einsatz, welche die Annäherung einer Hand des Benutzers an einen Türgriff des Fahrzeuges erkennen können. Auch kann es möglich sein, dass durch weitere Sensoren eine Berührung oder eine Kraftausübung auf den Türgriff erkannt wird. Bei positiver Detektion kann eine Fahrzeugfunktion ausgeführt werden, um z. B. ein Türschloss zu entriegeln.

Ein Nachteil bei bekannten Lösungen ist jedoch, dass die Detektion von Aktivierungshandlungen oft nur aufwendig und technisch komplex durchführbar ist. Insbesondere ist es problematisch, einen Bewegungsverlauf bei der Aktivierungshandlung zuverlässig zu erfassen oder ungewünschte oder ungewollte Aktivierungshandlungen zu vermeiden.

Es ist daher eine Aufgabe der vorliegenden Erfindung, die voranstehend genannten Nachteile zumindest teilweise zu reduzieren. Insbesondere ist es eine Aufgabe, ein verbessertes und/oder kostengünstiges und/oder zuverlässigeres System und Verfahren zur Detektion einer Aktivierungshandlung vorzuschlagen. Dabei sollen ggf. auch Störeinwirkungen (im Sinne eines Rauschens bei dem Sensor oder weiteren Störeinflüssen) zuverlässig von bewussten Aktivierungshandlungen unterschieden werden können.

Die voranstehende Aufgabe wird gelöst durch ein System mit den Merkmalen des unabhängigen Systemanspruchs und durch ein Verfahren mit den Merkmalen des unabhängigen Verfahrensanspruchs. Weitere Merkmale und Details der Erfindung ergeben sich aus den jeweiligen Unteransprüchen, der Beschreibung und den Zeichnungen. Dabei gelten Merkmale und Details, die im Zusammenhang mit dem erfindungsgemäßen System beschrieben sind, selbstverständlich auch im Zusammenhang mit dem erfindungsgemäßen Verfahren, und jeweils umgekehrt, so dass bezüglich der Offenbarung zu den einzelnen Erfindungsaspekten stets wechselseitig Bezug genommen wird bzw. werden kann.

Die Aufgabe wird insbesondere gelöst durch ein System zur Detektion wenigstens einer Aktivierungshandlung bei einem Fahrzeug, vorzugsweise eines Wischbewegungsverlaufs z. B. bei einem Türgriff und/oder einer Tür, insbesondere eines Türblechs, des Fahrzeuges, bevorzugt entlang des Türgriffs und/oder des Türblechs des Fahrzeuges, mit einem (insbesondere induktiven) Sensor zur Erfassung einer Induktivitätsveränderung in einem Erfassungsbereich, wobei der Sensor wenigstens ein Detektionsmittel zur Bereitstellung des Erfassungsbereichs aufweist. "Entlang" kann sich hierbei bspw. auf eine Richtung in Längsrichtung des Türgriffs (oder auch Fahrzeuglängsrichtung) und/oder orthogonal hierzu und/oder auf eine beliebige Richtung am Türgriff oder Fahrzeug beziehen. Bspw. kann die Wischbewegung horizontal und/oder vertikal entlang des Türgriffs erfolgen.

Hierbei kann vorgesehen sein, dass das wenigstens eine Detektionsmittel eine geometrische Anpassung aufweist, wobei die Anpassung für wenigstens einen (bestimmten) Verlauf der Aktivierungshandlung spezifisch ist. In anderen Worten kann die Anpassung für den Verlauf und/oder die Aktivierungshandlung charakteristisch sein.

Grundsätzlich kann dabei die Anpassung derart ausgeführt sein, dass die räumliche Erstreckung des Detektionsmittels dem räumlichen Bereich entspricht, in der die Aktivierungshandlung zumindest teilweise erfolgt (also im Erfassungsbereich). Darüber hinaus wird bei der geometrischen Anpassung auch der Verlauf der Aktivierungshandlung berücksichtigt, also insbesondere ein zeitlicher Verlauf, wie eine Bewegung (eines Aktivierungsmittels) oder dergleichen. Dafür ist es von Vorteil, wenn nicht (nur) die räumliche Erstreckung im Erfassungsbereich als die geometrische Anpassung verstanden wird, sondern eine weitergehende Anpassung erfolgt, welche den Verlauf repräsentiert. Damit kann die geometrische Anpassung bspw. eine definierte Änderung der Geometrie in Bewegungsrichtung des Verlaufs bzw. der Aktivierungshandlung aufweisen. Dies ermöglicht es, die erfasste Induktivitätsveränderung und damit ein Erfassungssignal, welches durch den Sensor in Abhängigkeit von der Erfassung bereitgestellt wird, so aufgrund der geometrischen Anpassung zu modifizieren, dass (nur) der wenigstens eine (Mess-)Verlauf der wenigstens einen Aktivierungshandlung ein (jeweiliges) charakteristisches Muster beim Erfassungssignal hervorruft, und somit von anderen (Mess-)Verläufen oder zufälligen Störeinflüssen unterscheidbar ist.

Beim zuvor Gesagten ist zu berücksichtigen, dass gerade induktive Sensoren eine hohe Messempfindlichkeit aufweisen und somit kleinste mechanische und/oder geometrische Veränderungen messtechnisch erfassen, wodurch es auch zu fehlerhaften Auslösungen bei einem Standardsensor kommen kann. Gerade diese fehlerhaften Auslösungen gilt es jedoch zu vermeiden.

Das Fahrzeug kann bspw. als ein Kraftfahrzeug, vorzugsweise als ein Personenkraftfahrzeug und/oder Lastkraftfahrzeug und/oder Elektrofahrzeug und/oder Hybridfahrzeug, ausgeführt sein. Das Fahrzeug kann wenigstens einen oder mehrere Sensoren aufweisen, durch welche jeweilige Aktivierungshandlungen bei dem Fahrzeug detektierbar sind. Hierzu stellen die Sensoren jeweilige Erfassungsbereiche am Fahrzeug bereit, z. B. im Bereich wenigstens eines Türgriffs und/oder im Bereich einer Heckklappe und/oder im Bereich eines Handschuhfachs und/oder im Bereich einer Tankklappe und/oder dergleichen. Von Vorteil ist es dabei, wenn die Aktivierungshandlung als eine (berührende und/oder krafteinwirkende) Bewegung eines Benutzers erfolgt, konkret insbesondere durch ein Aktivierungsmittel, wie eine Hand des Benutzers. Optional kann dabei zunächst durch (z. B. durch einen weiteren Sensor) eine Annäherung des Benutzers detektiert werden, und sodann eine Authentifizierung mit einem ID-Geber des Benutzers initiiert werden. Es ist möglich, dass erst nach erfolgreicher Authentifizierung die Detektion der Aktivierungshandlung durch den wenigstens einen Sensor möglich ist. Auch ist es denkbar, dass die Authentifizierung mit dem ID-Geber bei erfolgreicher Detektion der Aktivierungshandlung initiiert wird und/oder bei der Erfassung des wenigstens einen Sensors initiiert wird. Des Weiteren ist es von Vorteil, wenn nach erfolgreicher Authentifizierung und/oder Detektion der wenigstens einen Aktivierungshandlung durch den wenigstens einen Sensor zumindest eine Fahrzeugfunktion aktiviert wird. Dies kann bspw. die Entriegelung oder Verriegelung sowie das Öffnen oder Verschließen einer Schließvorrichtung bei dem Fahrzeug sein und/oder die Initiierung einer Öffnungs- oder Schließbewegung, z. B. einer Heckklappe und/oder eines Tankdeckels und/oder eines Handschuhfachs.

Beim dem erfindungsgemäßen System kann es sich insbesondere um ein (berührungsempfindliches) Zugangskontrollsystem für ein Fahrzeug handelt, wobei vorzugsweise entsprechende (induktive) Sensoren im Bereich eines Türgriffs oder einer Betätigungsvorrichtung zum Öffnen oder Schließen einer Tür, Klappe oder dergleichen vorgesehen sind. Zusätzlich kann das Zugangskontrollsystem mit einem mobilen ID-Geber ausgestattet sein, um z. B. eine elektronische Entriegelung des Systems zu bewirken. Zumindest eine Sensor (von den erwähnten Sensoren) kann innerhalb eines Türgriffkörpers oder hinter einem Karosserieblech ("Blech" unabhängig aus welchem Material, ob aus Metall, Aluminium oder Kunststoff oder Kombinationen) angeordnet sein, um somit eine übliche Berührung bzw. Betätigung durch einen Benutzer beim Öffnen oder Schließen messtechnisch erfassen und detektieren zu können. Damit kann ein besonders komfortabler und sicherer Zugang zum Fahrzeug erzielt werden.

Ein Verlauf, insbesondere ein Wischbewegungsverlauf, ist vorteilhafterweise durch eine Bewegung z. B. eines Aktivierungsmittels in wenigstens eine (ggf. eine einzige) bestimmte Richtung gekennzeichnet. Dabei ist es möglich, dass zwingend eine Berührung des Türgriffs während der Aktivierungshandlung und des Verlaufs erfolgen muss. Dies hat den Hintergrund, dass jede noch so leichte Berührung eine Kraftausübung auf den Türgriff bewirkt. Diese kann durch eine Veränderung der Induktivität bei dem Sensor ermittelt werden, und somit mit sehr hoher Empfindlichkeit erfasst werden. Um nun trotz der hohen Empfindlichkeit eine Fehldetektion der Aktivierungshandlung zu vermeiden, kann die geometrische Anpassung vorgesehen sein. Die geometrische Anpassung ist dabei bevorzugt derart ausgeführt, dass eine Aktivierungshandlung mit einem bestimmten Verlauf eine dafür kennzeichnende Erfassung durch den Sensor zur Folge hat. In anderen Worten kann eine zufällige Induktivitätsänderung (z. B. durch eine Belastung des Türgriffs aufgrund von Umwelteinflüssen) mit wechselnden Bewegungsrichtungen und/oder Bereichen der Induktivitätsänderung klar von einem bewussten und/oder zielgerichteten Verlauf der Aktivierungshandlung unterschieden werden. Bei einem solchen bewussten und/oder zielgerichteten Verlauf können die Bereiche der Induktivitätsänderung (im Wesentlichen) in eine bestimmte Richtung wandern, also einen räumlich stetigen Verlauf in diese Richtung aufweisen.

Optional kann es möglich sein, dass der Verlauf als ein Bewegungsverlauf ausgeführt ist, vorzugsweise mit einer definierten Richtung, und bevorzugt entlang einer Strecke von mindestens 1 cm oder mindestens 2 cm oder mindestens 5 cm erfolgt. Bspw. erfolgt der Verlauf durch eine Aktivierungsmittel, wie eine Hand eines Benutzers des Fahrzeuges.

Weiter ist im Rahmen der Erfindung denkbar, dass der Sensor als ein Kraft- und/oder induktiver Sensor, vorzugsweise als ein LDC-Sensor, ausgebildet ist. Ein LDC-Sensor ist ein kompakter elektronischer Sensor zur Erfassung einer Induktivitätsveränderung. Hierzu umfasst der LDC-Sensor bspw. mindestens einen Kondensator und/oder mindestens eine Spule, um einen Schwingkreis zur Induktivitätsmessung zu bilden. Auch kann der Sensor wenigstens einen elektrischen Widerstand aufweisen, welcher z. B. mit dem Kondensator und/oder mit weiteren elektronischen Bauelementen in einem integrierten Schaltkreis vorgesehen ist. Der integrierte Schaltkreis und/oder der Kondensator und/oder die Spule können dabei auf einer gemeinsamen Platine befestigt und/oder mit elektrischen Leiterbahnen der Platine elektrisch leitend verbunden sein. Vorteilhaft ist es zudem, wenn der Sensor eine Auswertevorrichtung, vorzugsweise einen Microcontroller, aufweist. Diese ist z. B. elektrisch mit dem Schwingkreis verbunden, um die Induktivitätsveränderung zu bestimmen. Des Weiteren kann das Detektionsmittel als die wenigstens eine Spule und/oder als eine elektrisch leitfähige Fläche, welcher zumindest eine Spule zugeordnet ist, ausgebildet sein. Auch ist es denkbar, dass die wenigstens eine Spule und/oder der wenigstens eine Kondensator jeweils als ein diskretes Bauteil ausgebildet ist, und insbesondere auch elektrisch leitend mit der Leiterbahn der Platine verbunden ist. Dabei kann in Abhängigkeit von der Ausbildung und/oder Erstreckung und/oder Form und/oder der Anzahl der Windungen der Spule der Erfassungsbereich definiert werden. Wenn das Detektionsmittel nicht als die Spule selbst sondern als ein andersartiges elektrisches Element, z. B. eine elektrisch leitfähige Fläche, ausgebildet ist, kann das Detektionsmittel bspw. benachbart (z. B. max. in einem Abstand von 1 cm oder 0,5 cm oder 1 mm) zu einer jeweiligen Spule oder auch im direkten elektrisch leitenden Kontakt mit der jeweiligen Spule angeordnet sein. Dies ermöglicht eine zuverlässige Erfassung der Induktivitätsveränderung im Erfassungsbereich.

Vorteilhaft ist es darüber hinaus, wenn im Rahmen der Erfindung die geometrische Anpassung dadurch für den Verlauf der Aktivierungshandlung spezifisch ist, dass die Geometrie des wenigstens einen Detektionsmittels räumlich wenigstens einem vorgegebenen Verlauf der Aktivierungshandlung folgt, insbesondere entlang einer Wegstrecke des Verlaufs ungleichmäßig ausgebildet ist. In anderen Worten kann die geometrische Anpassung als eine geometrische Codierung verstanden werden. Damit ist es möglich, dass nur bei einer Durchführung einer Aktivierungshandlung mit einem bestimmten vorgegebenen Verlauf im Erfassungsbereich durch den Sensor ein bestimmtes Erfassungssignal mit einem solchen Muster ausgegeben wird, welches für den Verlauf kennzeichnend ist. Der Verlauf kann dabei räumlich durch die geometrische Anpassung vorgegeben sein, bspw. durch eine über die Länge des Sensors veränderte Breite des Sensors. So kann der Sensor z. B. in Draufsicht eine keilförmige oder schmetterlingsförmige geometrische Anpassung aufweisen. Insbesondere bewirkt die Anpassung, dass unterschiedliche Bereiche, in denen Induktivitätsveränderungen erfolgen, durch die Erfassung des Sensors unterscheidbar sind.

Es ist bei dem erfindungsgemäßen System denkbar, dass die geometrische Anpassung eine derartige Geometrie des wenigstens einen Detektionsmittels umfasst, bei welcher die Erstreckung der Detektionsmittel in Breitenrichtung variiert. Bspw. kann die Breite des wenigstens einen Detektionsmittels sich in Bewegungsrichtung des Verlaufs verändern, z. B. zunehmen oder abnehmen. Auch ist es denkbar, dass ein erster vorgegebener Verlauf vorgesehen ist (z. B. eine Wischbewegung nach vorne) und wenigstens ein zweiter vorgegebener Verlauf vorgesehen ist (z. B. eine Wischbewegung nach hinten). Die Richtungsangaben beziehen sich dabei z. B. auf die Fahrzeugrichtung. Wenn nun das wenigstens eine Detektionsmittel eine abnehmende Breite (z. B. in Fahrtrichtung, also nach vorne, wenn der Sensor bei einem montierten Türgriff vorgesehen ist) aufweist, kann der erste vorgegebene Verlauf vom zweiten vorgegebenen Verlauf unterschieden werden und/oder der jeweilige Verlauf ein charakteristisches Erfassungssignal beim Sensor hervorrufen. Weiter ist es auch möglich, dass bei mehreren Detektionsmitteln die jeweiligen Detektionsmittel eine konstante Breite aufweisen, sich allerdings untereinander hinsichtlich der Breite unterscheiden.

Ein weiterer Vorteil kann im Rahmen der Erfindung erzielt werden, wenn das Detektionsmittel als eine Sensorfläche ausgebildet ist, welcher vorzugsweise zumindest ein Spulenelement zugeordnet ist, das Teil eines elektrischen Schwingkreises des Sensors zur Erfassung der Induktivitätsveränderung ist. Auch kann es möglich sein, dass mehrere Detektionsmittel vorgesehen sind, wobei jedem Detektionsmittel wenigstens ein Spulenelement zugeordnet ist und/oder jedes Detektionsmittel ein Spulenelement aufweist. Das Spulenelement ist bspw. als elektrische Spule, vorzugsweise als ein diskretes Bauteil, ausgebildet. Dabei kann das Spulenelement elektrisch mit wenigstens einem Kondensator und/oder wenigstens einem elektrischen Widerstand des Sensors verbunden sein, um den elektrischen Schwingkreis bereitzustellen. Bspw. wird bei mehreren Spulenelementen jeweils ein Schwingkreis bereitgestellt. Anhand einer Auswertung einer elektrischen Eigenschaft des Schwingkreises, z. B. durch eine Frequenzmessung, kann dabei eine Induktivitätsveränderung bei dem Spulenelement erfasst werden. Hierzu kann z. B. eine Resonanzfrequenz bzw. eine Sensorfrequenz ermittelt werden, welche sich in Abhängigkeit von der Induktivität verändert. Dies ermöglicht eine zuverlässige Erfassung und Detektion der Aktivierungshandlung. Insbesondere stellt die Erfassung der Induktivitätsveränderung als eine Veränderung der effektiven Induktivität des Schwingkreises, vorzugsweise anhand einer Erfassung einer Veränderung der Resonanzfrequenz bei dem Schwingkreis, eine zuverlässige und kostengünstige Möglichkeit zur Detektion der Aktivierungshandlung dar.

Des Weiteren kann vorgesehen sein, dass wenigstens zwei Detektionsmittel vorgesehen sind, welche zur Anpassung geometrisch unterschiedlich ausgebildet sind, um wenigstens ein (insbesondere jeweiliges) für die unterschiedliche Ausbildung kennzeichnendes Erfassungssignal bereitzustellen, wodurch das wenigstens eine Erfassungssignal für den Verlauf der Aktivierungshandlung spezifisch sind. Bspw. setzt sich das Erfassungssignal aus mehreren Erfassungswerten der Erfassung zusammen, wobei jeder Erfassungswert für die gemessene oder erfasste Induktivität bei dem Sensor spezifisch ist. In anderen Worten kann anhand eines zeitlichen Verlaufs der Erfassungswerte, welcher durch das Erfassungssignal bereitgestellt wird, die Induktivitätsveränderung bestimmt werden.

Des Weiteren ist es denkbar, dass wenigstens zwei Detektionsmittel vorgesehen und benachbart zueinander angeordnet sind, wobei sich die Detektionsmittel hinsichtlich ihrer Breite und/oder ihres Flächeninhalts und/oder ihrer Anzahl der Windungen voneinander unterscheiden, um die Anpassung bereitzustellen, vorzugsweise sich um wenigstens 10 % oder wenigstens 20 % oder wenigstens 40 % der Breite und/oder des Flächeninhalts voneinander unterscheiden. Wenn z. B. mindestens drei oder mindestens vier oder mindestens fünf oder mindestens sechs Detektionsmittel vorgesehen sind, kann es möglich sein, dass sich jedes dieser Detektionsmittel von den anderen hinsichtlich der Breite und/oder des Flächeninhalts und/oder ihrer Anzahl der Windungen voneinander unterscheidet. Damit ist ein konstruktiv einfacher Aufbau des Sensors möglich, durch welchen eine bewegungssensitive Erfassung der Aktivierungshandlung möglich ist.

Vorteilhafterweise kann bei der Erfindung vorgesehen sein, dass wenigstens zwei Detektionsmittel vorgesehen sind, welche derart geometrisch angepasst sind, dass sie (unter gleichen Voraussetzungen, gemeint ist bei gleicher Betätigung bzw. Krafteinwirkung) eine unterschiedliche Sensitivität für die Erfassung von Induktivitätsveränderungen aufweisen. Insbesondere kann somit durch die Gesamtheit der Detektionsmittel des Sensors eine richtungssensitive Erfassung von Induktivitätsänderungen möglich sein. Als Besonderheit der geometrischen Anpassung ist es dabei denkbar, dass diese Richtungssensitivität für wenigstens eine (oder genau eine einzige) Aktivierungshandlung, d. h. deren konkreten Verlauf, spezifiziert ist. In anderen Worten dient die Richtungssensitivität nicht zur Erfassung beliebiger Richtungen, sondern nur zur Erfassung des tatsächlichen Verlaufs der Aktivierungshandlung. Damit ist eine besonders zuverlässige Detektion möglich.

Ein weiterer Vorteil kann im Rahmen der Erfindung erzielt werden, wenn mindestens vier oder mindestens sechs oder mindestens acht Detektionsmittel vorgesehen sind, welche derart hinsichtlich ihrer geometrischen Erstreckung und/oder Anordnung angepasst sind, dass sie einen gemeinsamen trapezförmigen Erfassungsbereich bereitstellen, um die Induktivitätsveränderung richtungssensitiv zu erfassen. In anderen Worten ergibt die äußere Form sämtlicher angeordneter Detektionsmittel (im Wesentlichen) die Form eines Trapezes. Von Vorteil ist es dabei, wenn die Detektionsmittel nebeneinander in Längsrichtung des Sensors angeordnet sind, sodass vorzugsweise die äußere Form eine zunehmende oder eine abnehmende Breite in Längsrichtung aufweist. Hierdurch kann auch eine Richtungssensitivität für die Erfassung des Sensors bereitgestellt werden, welche für den Verlauf der Aktivierungshandlung mit einer Bewegungsrichtung in Längsrichtung spezifisch ist.

Nach einer weiteren Möglichkeit kann vorgesehen sein, dass das wenigstens eine Detektionsmittel an einer Platine befestigt ist, und beabstandet zu einem Gegendetektionsmittel angeordnet ist, um eine Relativbewegung zwischen dem Gegendetektionsmittel und dem Detektionsmittel zu erfassen. Dabei kann das Gegendetektionsmittel ein derartiges Material aufweisen, welches zur Beeinflussung einer Induktivität geeignet ist. Dies ist bspw. ein elektrisch leitfähiges Material, wie bspw. ein Metall, z. B. Kupfer oder dergleichen. Da die Aktivierungshandlung mit einer Berührung und/oder Kraftausübung auf ein Gehäuse des Sensors, z. B. auf ein Türgriffgehäuse, einhergehen kann, ist durch die Nutzung eines Gegendetektionsmittels eine verbesserte Detektion möglich. Hierzu kann das Gegendetektionsmittel derart an dem Gehäuse angeordnet sein, dass die Kraftausübung durch die Aktivierungshandlung eine Bewegung des Gegendetektionsmittels bewirkt.

Ein weiterer Vorteil im Rahmen der Erfindung ist erzielbar, wenn ein Gegendetektionsmittel zur Beeinflussung einer Induktivität bei dem Detektionsmittel vorgesehen ist, welches beweglich im Erfassungsbereich angeordnet ist, insbesondere beweglich in einem Türgriffgehäuse bei einem Türgriff des Fahrzeuges gelagert ist. Durch die Anordnung im Erfassungsbereich kann eine Kraftausübung durch die Aktivierungshandlung eine Bewegung des Gegendetektionsmittels bewirken. Es kann dabei möglich sein, dass auch das wenigstens eine Gegendetektionsmittel die geometrische Anpassung der Detektionsmittel aufweist und/oder komplementär dazu ausgebildet ist.

Ferner kann es im Rahmen der Erfindung vorgesehen sein, dass der Sensor in einem Türgriff des Fahrzeuges befestigt ist, wobei ein Türgriffgehäuse wenigstens eine Ausnehmung im Erfassungsbereich aufweist, wobei vorzugsweise jeweils wenigstens ein Gegendetektionsmittel in einer jeweiligen Ausnehmung befestigt ist. Auch hierbei kann es möglich sein, dass die wenigstens eine Ausnehmung die geometrische Anpassung der Detektionsmittel aufweist und/oder entsprechend der jeweiligen Gegendetektionsmittel, welche darin aufgenommen sind, ausgebildet sind. Dies ermöglicht einen konstruktiv einfachen und kostengünstigen Aufbau des Sensors.

Es kann von Vorteil sein, wenn im Rahmen der Erfindung ein Gegendetektionsmittel vorgesehen ist, welches als ein elektrisch leitendes Element und/oder Folie oder Beschichtung ausgebildet ist, um die Induktivitätsveränderung bei einer Bewegung des Gegendetektionsmittel durch die Aktivierungshandlung zu bewirken.

Beispielsweise kann es vorgesehen sein, dass der Sensor im Bereich eines Handschuhfachs des Fahrzeuges angeordnet ist, um eine Aktivierungshandlung zum Öffnen des Handschuhfachs zu detektieren. Bspw. kann bei einer erfolgreichen Detektion der Aktivierungshandlung eine Verriegelung des Handschuhfachs geöffnet werden und/oder ein Motor zum Öffnen des Handschuhfachs betrieben werden.

Ebenfalls Gegenstand der Erfindung ist ein Verfahren zur Detektion einer Aktivierungshandlung bei einem Fahrzeug, vorzugsweise eines Wischbewegungsverlaufs entlang eines Türgriffs und/oder einer Tür des Fahrzeuges, mit einem Sensor, welcher wenigstens ein Detektionsmittel aufweist, das einen Erfassungsbereich bereitstellt.

Vorteilhafterweise kann bei einem erfindungsgemäßen Verfahren zumindest einer der nachfolgenden Schritte durchgeführt werden, wobei die Schritte bevorzugt nacheinander oder in beliebiger Reihenfolge durchgeführt werden, und ggf. auch einzelne Schritte wiederholt werden können:
- Erfassen einer Induktivitätsveränderung in dem Erfassungsbereich durch den Sensor, sodass ein Erfassungssignal bestimmt wird,
- Auswerten des Erfassungssignals, wobei wenigstens ein Muster im Erfassungssignal identifiziert wird, welches für eine geometrische Anpassung des wenigstens einen Detektionsmittels spezifisch ist, um einen Verlauf der Aktivierungshandlung zu bestimmen.
Dabei bringt das erfindungsgemäße Verfahren die gleichen Vorteile mit sich, wie sie bereits ausführlich in Bezug auf ein erfindungsgemäßes System beschrieben worden sind. Zudem kann das Verfahren geeignet sein, ein erfindungsgemäßes System zu betreiben.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
- Figur 1: eine schematische Seitenansicht eines Fahrzeuges,
- Figur 2: eine schematische Draufsicht auf einen Sensor eines erfindungsgemäßen Systems,
- Figur 3: eine weitere schematische Draufsicht auf einen Sensor,
- Figur 4: eine schematische Seitenansicht auf einen Türgriff eines Fahrzeuges,
- Figur 5 und 6: schematische Darstellungen von Ausnehmungen bei einem Sensor eines erfindungsgemäßen Systems,
- Figur 7: eine schematische Darstellung von Erfassungssignalen eines Sensors eines erfindungsgemäßen Systems.

In den nachfolgenden Figuren werden für die gleichen technischen Merkmale auch von unterschiedlichen Ausführungsbeispielen die identischen Bezugszeichen verwendet.

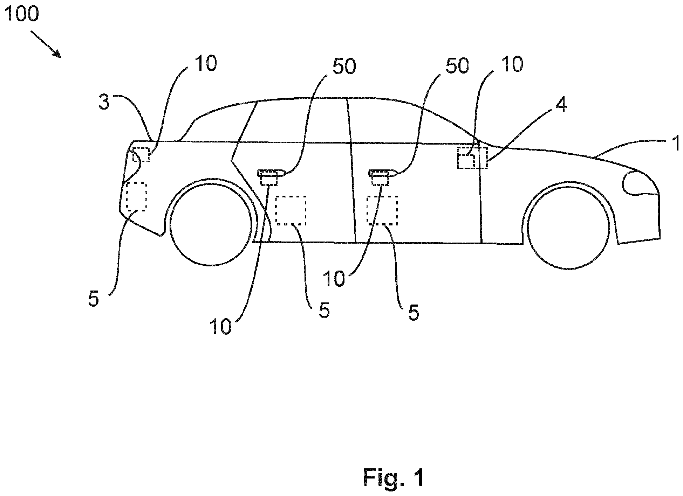

In Figur 1 ist schematisch eine Seitenansicht auf ein Fahrzeug 1 gezeigt. Dabei kann das Fahrzeug 1 ein erfindungsgemäßes System 100 aufweisen, um eine Aktivierungshandlung A bei dem Fahrzeug 1 zu detektieren, insbesondere durch die Ausführung eines erfindungsgemäßen Verfahrens. Entsprechend dienen die gezeigten Figuren auch zur Visualisierung eines erfindungsgemäßen Verfahrens.

Die Aktivierungshandlung A kann bspw. an einem Türgriff 50 und/oder im Bereich einer Heckklappe 3 und/oder im Bereich eines Handschuhfachs 4 des Fahrzeuges 1 durchgeführt werden. Dabei dient die Aktivierungshandlung A zur Aktivierung einer Fahrzeugfunktion, wie z.B. das Öffnen einer Schließvorrichtung 5 des Fahrzeuges 1. Auch kann die Fahrzeugfunktion umfassen, dass ein Antrieb bei dem Fahrzeug aktiviert wird, z. B. zum Öffnen der Heckklappe 3. Um die Aktivierungshandlung A zu erfassen, ist wenigstens ein Sensor 10 bei dem Fahrzeug 1 vorgesehen. Es ist dabei von Vorteil, wenn der Sensor 10 hierzu im Bereich des Türgriffs 50 und/oder der Heckklappe 3 und/oder des Handschuhfachs 4 angeordnet ist. Hierdurch wird ein Erfassungsbereich 15 durch den Sensor 10 bereitgestellt, welcher eine intuitive Bedienung durch einen Benutzer des Fahrzeuges 1 ermöglicht.

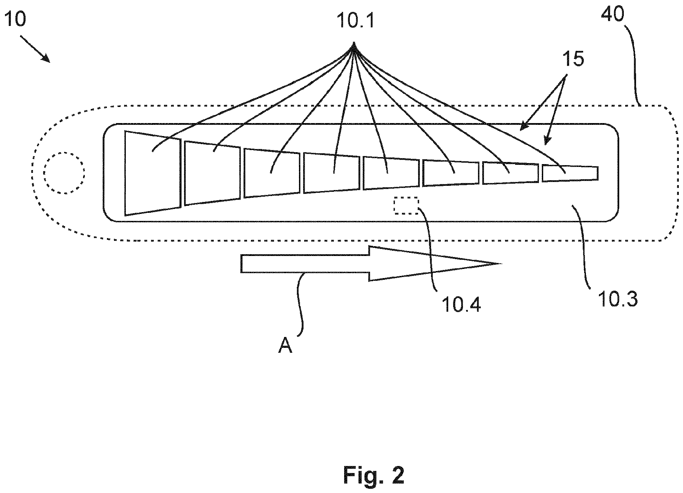

In Figur 2 ist schematisch eine Draufsicht auf einen Sensor 10, insbesondere induktiven Sensor, bevorzugt LDC-Sensor, gezeigt. Des Weiteren ist mit gestrichelten Linien ein Gehäuse 40 des Sensors 10 dargestellt, welches bspw. zur Montage in einem Türgriff 50 dient. Der Sensor 10 dient dazu, eine durch Kraftausübung, z. B. auf den Türgriff 50, hervorgerufene Induktivitätsveränderung zu erfassen. Beispielhaft ist der Sensor 10 mit acht Detektionsmitteln 10.1 dargestellt. Die Detektionsmittel 10.1 können jeweils als Sensorfläche 10.1, insbesondere als elektrisch leitende Fläche, und/oder als Spulenelement, ausgebildet sein. Es ist klar erkennbar, dass sich die Detektionsmittel 10.1 hinsichtlich ihrer Geometrie voneinander unterscheiden, und sowohl jeweils als auch die Anordnung sämtlicher Detektionsmittel 10.1 die äußere Form eines Trapezes aufweisen. Eine solche geometrische Anpassung der Detektionsmittel 10.1 mit einer abnehmenden Breite in Längsrichtung des Sensors 10 ermöglicht dabei eine Anpassung an den Verlauf der Aktivierungshandlung A. Es ist erkennbar, dass die Anordnung der Detektionsmittel 10.1 so erfolgt, dass die Längsrichtung des Sensors 10 der mit einem Pfeil dargestellten Bewegungsrichtung der Aktivierungshandlung A entspricht. In anderen Worten erfolgt eine Anordnung der Detektionsmittel 10.1 mit abnehmender Breite in Bewegungsrichtung der Aktivierungshandlung A. Somit wird ein Erfassungsbereich 15 bereitgestellt, bei welchem nur eine Aktivierungshandlung mit einem Verlauf in Richtung A (und/oder genau entgegengesetzt) eine charakteristische Erfassung des Sensors 10 ermöglicht. Dies wird insbesondere dadurch realisiert, dass aufgrund der verringerten Sensorfläche 10.1 in Richtung A bei gleicher Kraftausübung in Abhängigkeit von der Position entlang der Richtung A eine unterschiedliche Induktivitätsveränderung durch die Kraftausübung bewirkt wird. Dies kann bspw. durch eine Auswertevorrichtung 10.4 erfasst werden, welche ggf. mit den Detektionsmitteln 10.1 an einer Platine 10.3 des Sensors 10 angeordnet ist.

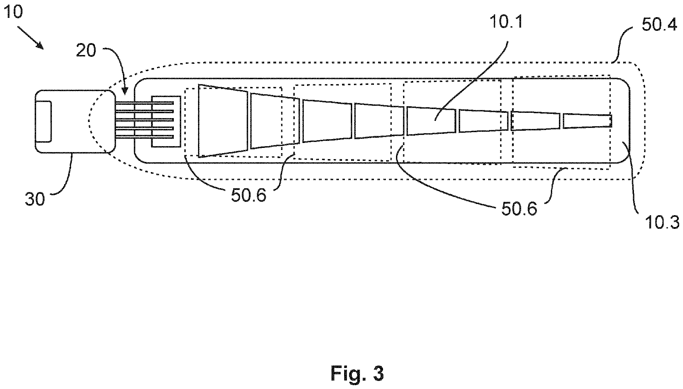

Figur 3 zeigt, dass der Sensor 10 zur Verbindung mit einer Fahrzeugelektronik des Fahrzeugs 1 ein Verbindungselement 30, insbesondere einen Stecker 30, aufweisen kann. Dieser ist bspw. über wenigstens ein Kabel 20 mit einer Platine 10.3 des Sensors 10 verbunden. Die Auswertevorrichtung 10.4 kann bspw. an der Platine 10.3 angeordnet sein und/oder durch die Fahrzeugelektronik bereitgestellt werden. Des Weiteren ist mit gestrichelten Linien schematisch ein Türgriffgehäuse 50.4 gezeigt, um die Einbaulage des Sensors 10 im Türgriff 50 zu visualisieren. Optional kann das Türgriffgehäuse 50.4 mehrere Ausnehmungen 50.6 aufweisen, in welchen bspw. Gegendetektionsmittel 10.2 zur Verbesserung der Detektion angeordnet sind. Die Aktivierungshandlung A am Türgriff 50 bewirkt dann eine Kraftausübung aufgrund der Berührung des Türgriffgehäuses 50.4, welche wiederum eine Verformung einer Wandung 50.5 im Bereich der Ausnehmungen 50.6 bewirkt. Dies kann eine Relativbewegung zwischen den Gegendetektionsmitteln 10.2 und den Detektionsmitteln 10.1 hervorrufen, was als Induktivitätsveränderung durch den Sensor 10 erfasst werden kann.

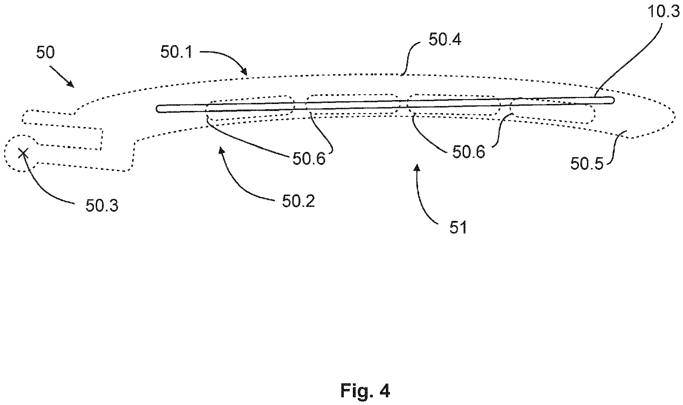

Figur 4 zeigt schematisch die Einbaulage eines Sensors 10 im Türgriff 50 aus einer seitlichen Perspektive. Dabei ist ein fahrzeugferner Bereich 50.1 und ein fahrzeugseitiger Bereich 50.2 des Türgriffgehäuses 50.4 gezeigt. Die Aktivierungshandlung A kann z. B. eine Berührung des fahrzeugfernen Bereichs 50.1 des Türgriffgehäuses 50.4 sein, also eine Berührung von außen an dem Türgriff 50. Alternativ oder zusätzlich kann die Aktivierungshandlung A eine Berührung des fahrzeugseitigen Bereichs 50.2 umfassen, also eine Berührung in der Türgriffmulde 51. Ebenfalls ist schematisch ein Lagerungspunkt 50.3 des Türgriffs 50 dargestellt, welcher eine Bewegung des Türgriffs 50 ermöglicht. Bspw. kann die Aktivierungshandlung A auch ein Ziehen am Türgriff 50 umfassen, insbesondere durch eine Berührung des fahrzeugseitigen Bereichs 50.2. In jedem Fall geht die Aktivierungshandlung A mit einer (zumindest geringfügigen) Kraftausübung auf das Türgriffgehäuse 50.4 und somit auch auf eine Wandung 50.5 des Türgriffs 50 einher. Diese bewirkt eine ggf. auch sehr geringe Krafteinwirkung auf wenigstens eine Ausnehmung 50.6, was eine Induktivitätsveränderung hervorrufen kann.

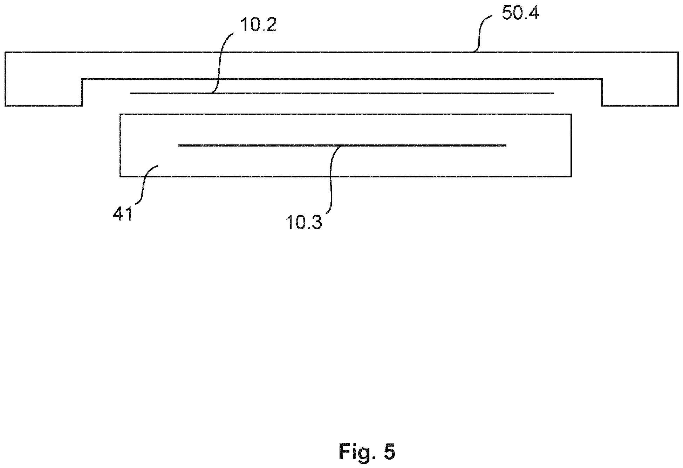

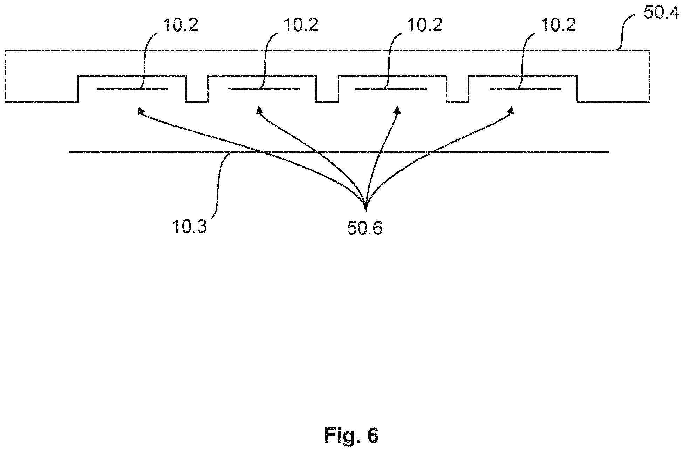

Dieses Prinzip ist in Figur 5 näher dargestellt. Hier ist erkennbar, dass wenigstens eine Ausnehmung 50.6 im Türgriffgehäuse 50.4 vorgesehen sein kann, welche ein Gegendetektionsmittel 10.2, insbesondere eine Metallfläche oder dergleichen, aufnimmt. Eine Kraftausübung auf das Türgriffgehäuse 50.4 kann dabei auf das Gegendetektionsmittel 10.2 übertragen werden und eine Relativbewegung zwischen dem Gegendetektionsmittel 10.2 und einem Detektionsmittel 10.1 auf einer Platine 10.3 des Sensors 10 hervorrufen. In Figur 6 ist gezeigt, dass auch mehrere Gegendetektionsmittel 10.2 in jeweiligen Ausnehmungen 50.6 vorgesehen sein können. Darüber hinaus ist auch gezeigt, dass die Platine 10.3 des Sensors 10 mit einer Vergussmasse 41 vergossen sein kann.

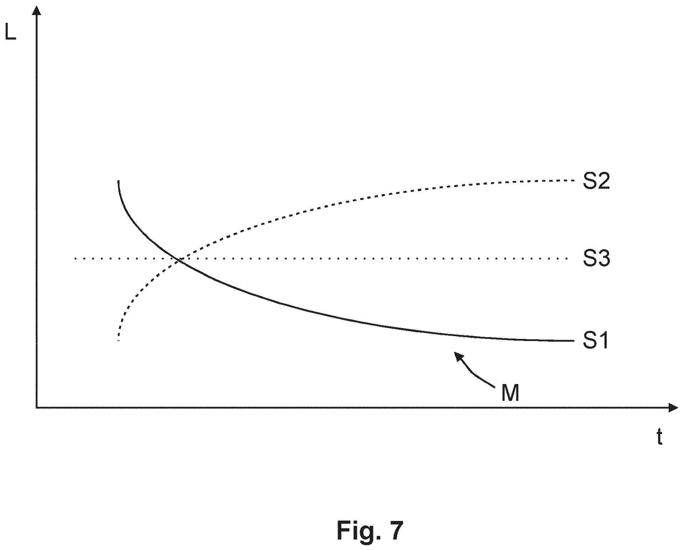

In Figur 7 ist schematisch ein Erfassungssignal eines Sensors 10 dargestellt. Beispielhaft erfolgt diese Darstellung als erfasste Induktivitätsveränderung L über die Zeit T. Aufgrund der geometrischen Anpassung des wenigstens einen Detektionsmittels 10.1 kann eine erste Aktivierungshandlung A mit einem Verlauf in eine Richtung A (wie durch den Pfeil gemäß Figur 2 gezeigt ist) die Erfassung eines ersten Erfassungssignals S1 bewirken. Dieses umfasst ein Muster M, welches für den Verlauf in Richtung A charakteristisch ist. Beispielhaft ist dieses Muster M ein abfallender Verlauf des ersten Erfassungssignals S1. Dieses ist dadurch begründet, dass aufgrund der abnehmenden Sensorfläche 10.1 in Richtung A auch die erfasste Induktivitätsveränderung bei gleichbleibender Kraftausübung durch die Aktivierungshandlung A geringer ausfällt. Entsprechend kann eine weitere Aktivierungshandlung mit einem Verlauf (also einer Bewegung) entgegen der Richtung A (wie durch den Pfeil gemäß Figur 2 gezeigt ist) ein Muster in einem zweiten Erfassungssignal S2 bewirken, welches einen steigenden Verlauf aufweist. Beide Erfassungssignale S1, S2 sind dabei deutlich von einem dritten Erfassungssignal S3 zu unterscheiden, welches kein charakteristisches Muster aufweist. Das Erfassungssignal S3 wird bspw. dann erfasst, wenn eine Bewegung bei der Aktivierungshandlung A ausbleibt und/oder nicht entlang einer Wegstrecke in Richtung A im Erfassungsbereich 15 erfolgt. Dies kann bspw. durch zufällige Kraftausübungen mit undefinierter Richtung (also ohne definierten Verlauf) z. B. durch Umwelteinflüsse hervorgerufen werden. Damit ermöglicht ein erfindungsgemäßes System 100 sowie ein erfindungsgemäßes Verfahren eine zuverlässige Detektion von Aktivierungshandlungen A und eine verbesserte Abgrenzung von Störeinflüssen.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 1: Fahrzeug
- 3: Heckklappe
- 4: Handschuhfach
- 5: Schließvorrichtung

- 10: Sensor, induktiver Sensor, LDC Sensor
- 10.1: Detektionsmittel, Sensorfläche
- 10.2: Gegendetektionsmittel, Metallfläche, Beschichtung, Folie
- 10.3: Platine
- 10.4: Auswertevorrichtung
- 15: Erfassungsbereich

- 20: Kabel

- 30: Verbindungselement, Stecker

- 40: Gehäuse
- 41: Vergussmasse

- 50: Türgriff
- 50.1: fahrzeugferner Bereich
- 50.2: fahrzeugseitiger Bereich
- 50.3: Lagerungspunkt
- 50.4: Türgriffgehäuse
- 50.5: Wandung
- 50.6: Ausnehmung
- 51: Türgriffmulde

- 100: System
- t: Zeit
- A: Aktivierungshandlung, Wischbewegung
- L: erfasste Induktivitätsveränderung
- M: Muster
- S1: erstes Erfassungssignal
- S2: zweites Erfassungssignal
- S3: drittes Erfassungssignal

## Patentansprüche

1. System (100) zur Detektion einer Aktivierungshandlung (A) bei einem Fahrzeug (1), vorzugsweise eines Wischbewegungsverlaufs (A) bei einem Türgriff (50) und/oder einer Tür des Fahrzeuges (1), mit
einem Sensor (10) zur Erfassung einer Induktivitätsveränderung in einem Erfassungsbereich (15), wobei der Sensor (10) wenigstens ein Detektionsmittel (10.1) zur Bereitstellung des Erfassungsbereichs (15) aufweist,
**dadurch gekennzeichnet,**
**dass** eine geometrische Anpassung des wenigstens einen Detektionsmittels (10.1) vorgesehen ist, wobei die Anpassung für einen Verlauf der Aktivierungshandlung (A) spezifisch ist.

2. System (100) nach Anspruch 1,
**dadurch gekennzeichnet,**
**dass** der Sensor (10) als ein Kraft- und/oder induktiver Sensor, vorzugsweise LDC-Sensor (10), ausgebildet ist.

3. System (100) nach Anspruch 1 oder 2,
**dadurch gekennzeichnet,**
**dass** die Anpassung dadurch für den Verlauf der Aktivierungshandlung (A) spezifisch ist, dass die Geometrie des wenigstens einen Detektionsmittels (10.1) räumlich wenigstens einem vorgegebenen Verlauf der Aktivierungshandlung (A) folgt, insbesondere entlang einer Wegstrecke des Verlaufs ungleichmäßig ausgebildet ist.

4. System (100) nach einem der vorhergehenden Ansprüche,
**dadurch gekennzeichnet,**
**dass** das Detektionsmittel (10.1) als eine Sensorfläche (10.1) ausgebildet ist, welcher vorzugsweise zumindest ein Spulenelement zugeordnet ist, das Teil eines elektrischen Schwingkreises des Sensors (10) zur Erfassung der Induktivitätsveränderung ist.

5. System (100) nach einem der vorhergehenden Ansprüche,
**dadurch gekennzeichnet,**
**dass** wenigstens zwei Detektionsmittel (10.1) vorgesehen sind, welche zur Anpassung geometrisch unterschiedlich ausgebildet sind, um wenigstens ein für die unterschiedliche Ausbildung kennzeichnendes Erfassungssignal bereitzustellen, wodurch das wenigstens eine Erfassungssignal für den Verlauf der Aktivierungshandlung (A) spezifisch ist.

6. System (100) nach einem der vorhergehenden Ansprüche,
**dadurch gekennzeichnet,**
**dass** wenigstens zwei Detektionsmittel (10.1) vorgesehen und benachbart zueinander angeordnet sind, wobei sich die Detektionsmittel (10.1) hinsichtlich ihrer Breite und/oder ihres Flächeninhalts voneinander unterscheiden, um die Anpassung bereitzustellen, vorzugsweise sich um wenigstens 10 % oder wenigstens 20 % oder wenigstens 40 % der Breite und/oder des Flächeninhalts voneinander unterscheiden.

7. System (100) nach einem der vorhergehenden Ansprüche,
**dadurch gekennzeichnet,**
**dass** wenigstens zwei Detektionsmittel (10.1) vorgesehen sind, welche derart geometrisch angepasst sind, dass sie eine unterschiedliche Sensitivität für die Erfassung von Induktivitätsveränderungen aufweisen.

8. System (100) nach einem der vorhergehenden Ansprüche,
**dadurch gekennzeichnet,**
**dass** mindestens vier oder mindestens sechs oder mindestens acht Detektionsmittel (10.1) vorgesehen sind, welche derart hinsichtlich ihrer geometrischen Erstreckung und/oder Anordnung angepasst sind, dass sie einen gemeinsamen trapezförmigen Erfassungsbereich (15) bereitstellen, um die Induktivitätsveränderung richtungssensitiv zu erfassen.

9. System (100) nach einem der vorhergehenden Ansprüche,
**dadurch gekennzeichnet,**
**dass** das wenigstens eine Detektionsmittel (10.1) an einer Platine (10.3) befestigt ist, und beabstandet zu einem Gegendetektionsmittel (10.2) angeordnet ist, um eine Relativbewegung zwischen dem Gegendetektionsmittel (10.2) und dem Detektionsmittel (10.1) zu erfassen.

10. System (100) nach einem der vorhergehenden Ansprüche,
**dadurch gekennzeichnet,**
**dass** ein Gegendetektionsmittel (10.2) zur Beeinflussung einer Induktivität bei dem Detektionsmittel (10.1) vorgesehen ist, welches beweglich im Erfassungsbereich (15) angeordnet ist, insbesondere beweglich in einem Türgriffgehäuse (50.4) bei einem Türgriff (50) des Fahrzeuges (1) gelagert ist.

11. System (100) nach einem der vorhergehenden Ansprüche,
**dadurch gekennzeichnet,**
**dass** der Sensor (10) in einem Türgriff (50) des Fahrzeuges (1) befestigt ist, wobei ein Türgriffgehäuse (50.4) wenigstens eine Ausnehmung (50.6) im Erfassungsbereich (15) aufweist, wobei vorzugsweise jeweils wenigstens ein Gegendetektionsmittel (10.2) in einer jeweiligen Ausnehmung (50.6) befestigt ist.

12. System (100) nach einem der vorhergehenden Ansprüche,
**dadurch gekennzeichnet,**
**dass** ein Gegendetektionsmittel (10.2) vorgesehen ist, welches als ein elektrisch leitendes Element und/oder Folie oder Beschichtung ausgebildet ist, um die Induktivitätsveränderung bei einer Bewegung des Gegendetektionsmittel (10.2) durch die Aktivierungshandlung (A) zu bewirken.

13. System (100) nach einem der vorhergehenden Ansprüche,
**dadurch gekennzeichnet,**
**dass** der Sensor (10) im Bereich eines Handschuhfachs (4) des Fahrzeuges (1) angeordnet ist, um eine Aktivierungshandlung (A) zum Öffnen des Handschuhfachs zu detektieren.

14. Verfahren zur Detektion einer Aktivierungshandlung (A) bei einem Fahrzeug (1), vorzugsweise eines Wischbewegungsverlaufs (A) bei einem Türgriff (50) und/oder einer Tür des Fahrzeuges (1), mit einem Sensor (10), welcher wenigstens ein Detektionsmittel (10.1) aufweist, das einen Erfassungsbereich (15) bereitstellt,
**wobei die nachfolgenden Schritte vorgesehen sind:**
- Erfassen einer Induktivitätsveränderung in dem Erfassungsbereich (15) durch den Sensor (10), sodass ein Erfassungssignal bestimmt wird,
- Auswerten des Erfassungssignals, wobei wenigstens ein Muster (M) im Erfassungssignal identifiziert wird, welches für eine geometrische Anpassung des wenigstens einen Detektionsmittels (10.1) spezifisch ist, um einen Verlauf der Aktivierungshandlung zu bestimmen.

15. Verfahren (100) nach einem der vorhergehenden Ansprüche,
**dadurch gekennzeichnet,**
**dass** ein System (100) nach einem der vorhergehenden Ansprüche zur Erfassung betrieben wird.
